(19) Europäisches Patentamt / European Patent Office / Office européen des brevets

(11) **EP 2 913 354 B1**

(12) **EUROPEAN PATENT SPECIFICATION**

(45) Date of publication and mention of the grant of the patent:
**21.10.2020 Bulletin 2020/43**

(21) Application number: **14863038.7**

(22) Date of filing: **19.02.2014**

(51) Int Cl.:
***C08J 5/24*** (2006.01)

(86) International application number:
**PCT/CN2014/072233**

(87) International publication number:
**WO 2015/106479 (23.07.2015 Gazette 2015/29)**

(54) **CIRCUIT SUBSTRATE AND PREPARATION METHOD THEREOF**

SCHALTUNGSSUBSTRAT UND VERFAHREN ZUR HERSTELLUNG DAVON

SUBSTRAT DE CIRCUIT ET PROCÉDÉ DE PRÉPARATION CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.01.2014 CN 201410016714**

(43) Date of publication of application:
**02.09.2015 Bulletin 2015/36**

(73) Proprietor: **Shengyi Technology Co., Ltd.**
**Guangdong 523808 (CN)**

(72) Inventors:
• **YAN, Shanyin**
  **Dongguan**
  **Guangdong 523808 (CN)**
• **ZENG, Xianping**
  **Dongguan**
  **Guangdong 523808 (CN)**
• **XU, Yongjing**
  **Dongguan**
  **Guangdong 523808 (CN)**
• **YANG, Zhongqiang**
  **Dongguan**
  **Guangdong 523808 (CN)**
• **SU, Xiaosheng**
  **Dongguan**
  **Guangdong 523808 (CN)**
• **LUO, Li**
  **Dongguan**
  **Guangdong 523808 (CN)**

(74) Representative: **Wallinger, Michael**
**Wallinger Ricker Schlotter Tostmann**
**Patent- und Rechtsanwälte Partnerschaft mbB**
**Zweibrückenstrasse 5-7**
**80331 München (DE)**

(56) References cited:
| | |
|---|---|
| WO-A2-2010/011701 | CN-A- 102 114 453 |
| CN-A- 102 166 852 | CN-U- 201 872 349 |
| JP-A- 2005 015 729 | JP-A- 2006 232 952 |
| US-A1- 2009 169 842 | |

• DATABASE WPI Week 200150 Thomson Scientific, London, GB; AN 2001-459489 XP002765385, -& JP 2001 031782 A (MATSUSHITA ELECTRIC WORKS LTD) 6 February 2001 (2001-02-06)
• DATABASE WPI Week 200367 Thomson Scientific, London, GB; AN 2003-699972 XP002765237, -& JP 2003 017820 A (HITACHI CHEM CO LTD) 17 January 2003 (2003-01-17)

**Description**

**Field of the invention**

The present invention, belonging to the technical field of electronic materials, relates to a circuit substrate and a process for preparing the same. Specifically, the present invention relates to a circuit substrate having microscopic homogeneity and isotropy and a process for preparing the same. More specifically, the present invention relates to a circuit substrate having less warp-wise and weft-wise difference in dielectric constant, as well as a process for preparing the same.

**Background of the invention**

In recent years, with the development of electronic products in the direction of multifunctionality and miniaturization, of circuit substrates used therein in the direction of multilayer, wiring densification and of signal transmission in the direction of high speed, higher requirements on the comprehensive performance of circuit substrates-metal foil-clad laminates, e.g. copper-clad plates, have be raised. Specifically, dielectric constant (Dk) and dielectric loss (Df) of the media are important indexes affecting signal transmission rate and signal quality. As for transmission rate, the lower the dielectric constant of the dielectric material is, the faster the signal transmission rate is. As for signal integrity, the dielectric loss property of the materials results in signal loss during the transmission, which will sharply increase with the increase of the transmission frequency and transmission line length. As for the substrate, signal integrity is mainly relevant to the dielectric loss of the dielectric materials, and the surface roughness of copper foil conductor. The lower the dielectric loss of the dielectric materials is, the less the signal transmission loss is, especially under the transmission circumstance of high frequency and long link.

Meanwhile, with the development of high performance, high functionality and networking of information communication equipment, data transmission rate will become higher and higher, faster and faster at the cloud computing and big data eras. Data transmission rate is increased from the conventional 5 Gbps to 10 Gbps, even 25 Gbps. When data transmission rate becomes higher and higher, the transmission wavelength of digital signal becomes shorter and shorter. When the transmission rate is at a lower level, signal time delay will have a less effect on the signal integrity since the transmission wavelength of digital signal is longer. However, when the transmission rate is higher than 10 Gbps, signal time delay will become a problem which must be considered in high-speed transmission links.

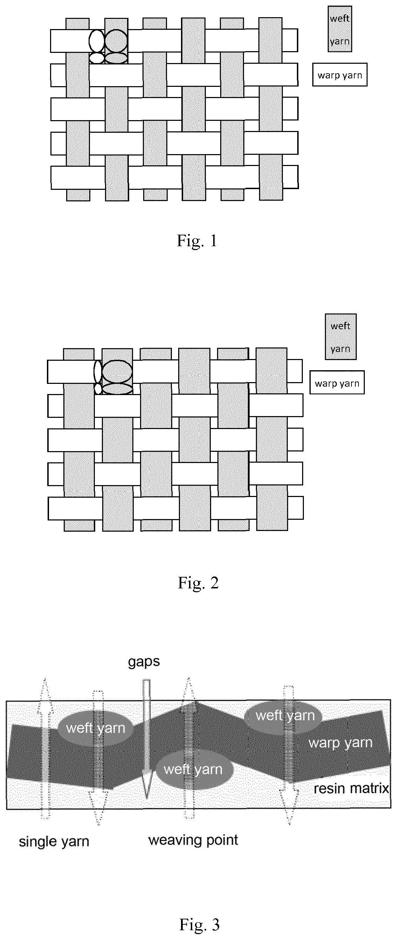

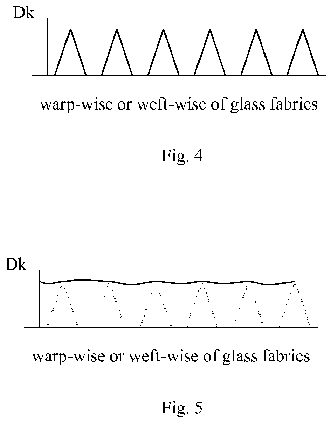

As one of the signal transmission supports of communication equipment, copper-clad laminates play a key role during signal transmission. The laminate materials as the transmission media determine the signal transmission quality. Currently, copper-clad laminate materials generally use electronic-grade glass fabrics as reinforcing materials, and are obtained by being impregnated with thermosetting resin, oven-dried, laminated and hot-pressed. Since weaving materials are used as reinforcing materials (e.g. glass fabrics), the insulating media (e.g. glass components) in the circuit substrates are not homogeneously distributed due to the weaving of woven fiber cloth and the existence of cross-shaped joints of cross sections of woven fibers, as shown in Fig.1-Fig.5.

In order to solve such problem, dielectric materials which are homogeneous in planar direction are radically necessary, wherein the main technical means include (1) increasing the fiber-opening extent of glass fabrics, (2) replacing the fiber weaving materials with film-form reinforcing materials, and (3) using reinforcing materials having a lower dielectric constant, e.g. glass fabrics having a low dielectric constant. Although the fiber-opening makes glass fabrics more homogeneous, only weft-wise homogeneousness can be achieved at present due to the weaving technology and structure of glass fabrics. In warp-wise direction, it is looser than conventional non-fiber-opened fiber cloth, and complete fiber-opening and homogeneity cannot be reached. Therefore glass fabrics cannot achieve complete homogeneity in planar direction. The film form will lead to great difficulty during the technology implementation, worse operability and binding to resins, and being easy to stratify. The use of glass fabrics having a low dielectric constant may decrease the dielectric constant of the reinforcing materials at a certain extent, but still increases the difference in the dielectric constant of currently used resin compositions having a low dielectric constant, so as to satisfy no homogeneity in the planar direction of dielectric constant.

Up to date, those skilled in the art, in order to adapt to the technical requirements of high-speed communications on copper-clad laminate materials, decrease the dielectric constant and dielectric loss by all kinds of technical means, generally in the following two aspects. One is to replace conventional epoxy resin with modified epoxy resin, cyanate resin, bismaleimide resin, polyphenyl ether resin, hydrocarbon resin, thermoplastic material-polytetrafluoroethylne, liquid crystal resin and the like. These resin materials *per se* have very low dielectric constant and dielectric loss, and may provide better high-speed transmission characteristics. Additionally, changes of the reinforcing materials may also reduce the dielectric constant and dielectric loss of copper-clad laminate materials. Since the current general reinforcing materials are electronic-grade glass fabrics (E-type glass fabrics) which have a dielectric constant of from 6.2 to 6.6, which is much higher than that of the resin portion used therein, the copper-clad laminate materials manufactured therefrom usually have a Dk of from 3.5 to 4.5. In order to further reduce the dielectric constant of laminate materials, those skilled in the art bring forward replacing the conventional electronic-grade glass fabrics with glass fabrics with low dielectric constant. Glass fabrics with low dielectric constant have a Dk of from 4.4 to 4.6, which may substantially reduce the dielectric constant of the whole laminate material and effectively increase the signal transmission rate. In addition, the dielectric loss (Df) is also lower than that of the electronic-grade glass fabrics, which is also in favor of improving the loss during signal transmission and can notably improve signal integrity brought by the increase of signal transmission rate and frequency.

It can be seen from above that there are two essential ingredients of copper-clad laminate materials, i.e. resin composition and reinforcing material. The difference of these two ingredients in dielectric constant is reflected in that the Dk of the reinforcing material is far greater than the Dk of the resin composition, as specifically stated in the following table.

| Ingredients | DK |
|---|---|
| Epoxy resin | 3.5~3.9 |
| Cyanate | 2.8~3.2 |
| Bismaleimide | 3.0~3.5 |
| Polyphenyl ether | 2.4~2.6 |
| Hydrocarbon resin | 2.2~2.6 |
| polytetrafluoroethylene | 2.2~2.4 |
| Liquid crystal resin | 2.2~2.6 |
| Electronic-grade glass fabrics | 6.2~6.6 |
| Glass fabrics having a low Dk | 4.4~4.6 |
| Quartz glass fabrics | 3.8~4.0 |

According to the table above, it can be obviously seen that the dielectric constant of the resin composition currently applied in high-speed materials is apparently lower than that of the reinforcing material-glass fabrics, and the dielectric constant of the final laminate is the weighted sum of those of the resin composition and reinforcing material, as shown in the following formulas.

$$Dk_{laminate} = Dk_{resin} \times V_{resin} + Dk_{reinforcing\ material} \times V_{reinforcing\ material}$$

$Dk_{laminate}$: dielectric constant of the laminate materials;

$Dk_{resin}$: dielectric constant of the resin;

$V_{resin}$: volume parts of the resin;

$Dk_{reinforcing\ material}$: dielectric constant of the reinforcing material;

$V_{reinforcing\ material}$: volume parts of the reinforcing material.

It is easy to see from the microstructure that micro-structural inhomogeneity of braided structure of the reinforcing materials results in a very high Dk, of the copper-clad laminates composed of resin compositions and reinforcing materials, at the places where the warp and weft yarns are interweaved, a quite high Dk at the places where there are warp or weft yarns, and a low Dk at the places where there are no yarns. Such inhomogeneity leads to micro-difference in dielectric constant of the dielectric layers.

Transmission time of signals is determined by the transmission rate and distance. Under the circumstance of the same transmission distance, transmission rate is inversely proportional to the dielectric constant of the transmission medium. Micro-differences in the dielectric constants of the surrounding media corresponding to the transmission lines directly result in time inconsistency of signals from the emitting end to the receiving end and signal mismatching, *i.e.* time delay effect. Signal time delay is divided into warp-wise signal time delay and weft-wise signal time delay. Warp-wise signal time delay refers to the signal time delay when the transmission line is warp-wisely arranged on the circuit substrate, and weft-wise signal time delay refers to the signal time delay when the transmission line is weft-wisely arranged on the circuit substrate.

In conclusion, with the continual increasing of the data transmission rate, time delay has become a problem which must be encountered during signal transmission in high-speed links. Currently, time delay will be reduced by some designing means at a certain extent, which, however, will greatly increase the cost. Therefore, it has become an important technical problem how to increase the micro-homogeneity of the dielectric materials--laminates on the basis of the dielectric materials per se and to solve the problem of signal delay radically.

As stated above, the structure characteristics of the current reinforcing materials result in plane inhomogeneity of the laminate materials, anisotropic dielectric constant and dielectric loss of the laminate material in the microstructure, as well as great micro-difference in different place in the same planar direction. During the designing process of high-speed digital circuits, various measures are taken by engineers to solve the problem of signal integrity, wherein one is the method of transmitting high-speed digital signal with differential lines. Differential lines in PCB are coupled strip-lines or coupled microstrip lines, and signals when transmitted thereon are in an odd mode transmission way. Therefore differential signals have the advantages of strong resistance to interference, being easy to match and the like. With the increasing demand on information transmission rate of digital circuit, differential transmission mode of signals will get more and more widely used. Differential lines have the main advantages of strong resistance to interference, effective inhibition of electromagnetic interference, timing precision positioning and the like. Hence, high-speed signal transmission with differential lines not is only of great advantage of signal integrity and low power consumption of PCB system, but also has a higher demand on the PCB designing level.

CN102548200A discloses a circuit substrate, comprising glass film forming a rough layer by surface roughening, resin adhesive layers on the rough layers respectively located on both sides of glass film, and metal foil located on the outside of the resin adhesive layer, wherein said glass film, resin adhesive layer and metal foil are combined together by pressing. During pressing, glass film is fragile. Moreover, the surface roughening process of glass film is complex and hard to control. Meanwhile, the roughening process will destroy the isotropy of glass film at a certain extent. In addition, the process by using glass film is different from that by using conventional copper-clad plate, since equipment upgrading and adjustment are necessary.

EP1140373A discloses impregnating glass fabrics with the solution having a relatively low solid content and containing curable resin, drying and impregnating with the solution having a relatively high solid content and containing curable resin, finally curing, increasing solvent content and reducing viscosity by decreasing the solid content of the resin solution with the purpose of increasing the resin permeability to reduce the gap amount in semi-cured sheets and cured products. However, it is not disclosed therein how to reduce Dk and solve the problem of signal time delay.

CN101494949A discloses fiber-opening or flattening glass cloth before the gluing process, impregnating in epoxy resin varnish, oven-drying to obtain an insulating material layer, so as to reduce signal loss of copper-clad laminate and to increase signal velocity and decrease production cost.

CN101570640B discloses preparing prepregs by using quartz glass fabrics (preferably fiber-opened), having a discrete intensity, of quartz glass fibers, and thermoplastic resin composition having a dielectric loss of less than 0.003, and applying in high frequency materials to ensure dielectric constant and to improve processing performance.

The aforesaid patents do not consider or mention how to simply and conveniently solve the signal time delay in plane direction, *i.e.* warp-wise and weft-wise directions, of circuit substrates during conventional production process.

**Summary of the invention**

One object of the invention lies in providing a process for preparing a bonding sheet for composing circuit substrate, comprising the step of carrying on special pre-treatment for reinforcing material. The circuit substrate prepared thereby has excellent dielectric properties, less warp-wise and weft-wise difference in dielectric constant, so as to realize micro consistency of dielectric constant.

In order to achieve this object, the invention provides a process for preparing a bonding sheet for composing a circuit substrate, comprising the steps of:

(1) preparing a pre-treating varnish having a dielectric constant (DK) equal to DK $\pm$ 5% of glass fabric being used, the dielectric constant is measured by SPDR method under a frequency of 10 GHz;
(2) pre-glue-dipping the glass fabric in the pre-treating varnish, and oven-drying solvent to obtain a pre-treated glass fabric; and
(3) main-glue-dipping the pre-treated glass fabric, and oven-drying solvent to obtain a bonding sheet;

wherein the pre-treated glass fabric has a resin content of from 25 wt.% to 50 wt.% and has a mass per unit area of less than 30 g/m$^2$; or alternatively, the pre-treated glass fabric has a resin content of from 20 wt.% to 45 wt.% and has a mass per unit area of from 30 g/ m 2 to 100 g/m$^2$; or alternatively, the pre-treated glass fabric has a resin content of from 20 wt.% to 40 wt.% and has a mass per unit area of from 100 g/m$^2$ to 175 g/m$^2$.

In some embodiments, the pre-treating varnish is obtained by dissolving a resin composition in an organic solvent. Preferably, the varnish further comprises a filler.

In some preferred embodiments, the resin composition comprises a resin and a hardener, wherein the resin is one or a mixture of at least two selected from the group consisting of epoxy resin, cyanate resin, polyphenyl ether resin, polybutadiene resin, copolymer resin of polybutadiene and styrene, polytetrafluoroethylene resin, polybenzoxazine resin, polyimide, silicon-containing resin, bismaleimide resin, liquid crystal polymer, bismaleimide triazine resin and thermoplastic resin. The hardener is one or more selected from the group consisting of phenolic hardener, amine hardener, polymeric acid anhydride hardener, active ester and free radical initiator. The organic solvent is one or a mixture of at least two selected from the group consisting of alcohol such as methanol, ethanol, butanol and the like, ether such as ethyl cellosolve, butyl cello solve, ethylene glycol mono methyl ether, diethylene glycol ether, diethylene glycol butyl ether and the like, ketone such as acetone, butanone, methyl ethyl ketone, methyl isobutyl ketone, cyclohexanone and the like, aromatic hydrocarbon such as toluene, xylene, sym-trimethylbenzene and the like, ester such as ethoxyethyl acetate, ethyl acetate and the like, and nitrogen-containing solvent such as N,N-dimethylformamide, N,N-dimethylacetamide, N-methyl-2-pyrrolidone and the like. Preferably, the resin composition further comprises a filler selected from the group consisting of silica, alumina, titanium dioxide, barium titanate, strontium titanate, magnesium titanate, calcium titanate, barium strontium titanate, lead titanate and glass dust, wherein said silica comprises molten amorphous silica and crystalline silica, preferably molten amorphous silica; said titanium dioxide comprises rutile-type titanium dioxide and anatase type titanium dioxide, preferably rutile-type titanium dioxide.

In some preferred embodiments, the reinforcing material is selected from electronic-grade glass fabric, and glass fiber nonwoven fabric.

More preferably, the reinforcing material is electronic-grade glass fabric. Preferably, the pre-treated reinforcing material above is a pre-treated glass fabric.

In some preferred embodiments, the pre-treated glass fabric has a resin content of from 20 wt.% to 50 wt.%.

The pre-treated glass fabric has a resin content of from 25 wt.% to 50 wt.% when the pre-treated glass fabric has a mass per unit area of less than 30 g/m$^2$. The pre-treated glass fabric has a resin content of from 20 wt.% to 45 wt.% when the pre-treated glass fabric has a mass per unit area of from 30 g/m$^2$ to 100 g/m$^2$. The pre-treated glass fabric has a resin content of from 20 wt.% to 40 wt.% when the pre-treated glass fabric has a mass per unit area of from 100g/m$^2$ to 175 g/m$^2$.

In some other preferred embodiments, the glass fabric is an E-type one, and the corresponding pre-treating varnish has a DK of from 6.2 to 6.6.

In some other preferred embodiments, the glass fabric is an NE-type one, and the corresponding pre-treating varnish has a DK of from 4.4 to 4.6.

In some other preferred embodiments, the resin has a DK within the range of DK±10%, preferably DK±5% of glass fabric.

The second object of the present invention lies in providing a bonding sheet prepared according to the process of the present invention.

The third object of the present invention lies in providing a circuit substrate prepared from the bonding sheet according to the present invention.

**Brief description of the drawings**

Fig.1 illustrates the planar structure diagram of E-type glass fabrics.
Fig.2 illustrates the planar structure diagram of E-type glass fiber fiber-opened cloth.
Fig.3 illustrates the cross-section diagram of E-type glass fabrics.
Fig.4 illustrates the plane inhomogeneity of the dielectric constant of E-type glass fabrics.
Fig.5 illustrates the plane homogeneity of the dielectric constant of the pre-treated E-type glass fabrics.

**Detailed description of the invention**

Dk of the present invention refers to dielectric constant measured by SPDR method under a frequency of 10 GHz.

Df of the present invention refers to dielectric loss measured by SPDR method under a frequency of 10 GHz.

The glass fabrics of the present invention refer to glass fiber cloth, and comprise E-type glass fabrics, NE-type glass fabrics, S-type fabrics, D-type glass fabrics and the like, wherein each type of glass fabrics may be divided into the specifications and models, such as 7628, 2116, 1080, 106, 1037, 1078, 2112, 3313, 1500 and the like. Those skilled in the art know very well that glass fabrics are mainly used as reinforcing materials of circuit substrate when applied in the field of circuit substrate.

The resin composition of the present invention refers to a composition comprising resins and hardeners. For example, the epoxy resin composition refers to a composition comprising epoxy resins and suitable hardeners. Those skilled in the art not only can choose suitable hardeners and the amount thereof according to the resin used therein, but also can choose suitable organic solvents according to the resins and hardeners used therein.

The filler of the present invention refers to filling materials. The object of using fillers in the copper-clad plate industry is not just for lowering the cost, but also to increase the performance of the copper-clad plate, for example decreasing CTE, increasing the flame resistance, increasing the heat conductivity coefficient and the mechanical property of plates. With the development of the filler technology, more new fillers are used in copper-clad plates, for example, the functional filler for adjusting Dk of the pre-treating varnish in the present invention.

The pre-treating varnish in the present invention refers to one in which the resin composition of the present invention is dissolved in suitable organic solvent. Preferably, the pre-treating varnish of the present invention refers to a disperse system obtained by dissolving the resin composition of the present invention in suitable organic solvent and then adding fillers. By adjusting the amount of the fillers in the pre-treating varnish, those skilled in the art can make the pre-treating varnish have a suitable dielectric constant (Dk). In the present invention, the Dk of the pre-treating varnish is the Dk of the dry glue obtained by removing solvent from the pre-treating varnish. Such value is only relevant to the amounts of the resin composition and filler, but irrelevant to the amount of the solvent.

Glue-dipping of the present invention refers to dipping glass fabrics into the varnish, and then oven-drying solvent on the gluing machine.

Pre-glue-dipping of the present invention refers to dipping glass fabrics into the prefabricated varnish, and then oven-drying solvent on the gluing machine.

Main-glue-dipping of the present invention refers to dipping glass fabrics into the main varnish, and then oven-drying solvent on the gluing machine.

The resin content of the present invention refers to the mass percent of the solid composition including the resin, besides the reinforcing material, i.e. glass fabrics, in the pre-treated glass fabrics, bonding sheet and circuit substrate. For example, if the resin composition formula of the varnish comprises resins, hardeners and fillers, the resin content will be the mass percent of resins, hardeners and fillers. Resin content is a fixed vocabulary in the art. Those skilled in the art know that the resin content can be controlled by adjusting the technological parameters, such as the gap of the clip axis of the gluing machine, gluing speed of the gluing machine and the like, in combination with the solid content of the pre-treating varnish.

In order to pre-treat the current glass fabrics (e.g. E-type glass fabrics, NE-type glass fabrics), the specific method is to pre-treat glass fabrics with a pre-treating varnish having a Dk equivalent to that of glass fabrics and good matching attributes, to fill the grids and gaps of glass fabrics as the basic control object, to make less warp-wise and weft-wise difference in the dielectric constant thereof, so as to form semi-product, *i.e.* pre-treated glass fabrics, of the reinforcing material for main-glue-dipping.

According to the present invention, the pre-treating varnish is a resin having a Dk equal to Dk±5% of glass fabrics. The closer the Dk is to the Dk of glass fabrics, the less the warp-wise and weft-wise difference in the dielectric constant is, and the less the signal delay is.

According to the present invention, the glass fabric is either of E-type and NE-type glass fabric.

According to the present invention, the E-type glass fabric is pre-treated, wherein the pre-treating varnish has a DK (10GHz) of 6.2-6.6.

According to the present invention, the NE-type glass fabric is pre-treated, wherein the pre-treating varnish has a DK (10GHz) of 4.4-4.6.

According to the present invention, the pre-treated glass fabric has a resin content of from 20 wt.% to 50 wt.%.

If the resin content is too higher, the pre-dipped varnish after main dipping will be mixed with the main-dipped varnish, so as to affect the gluing amount; if the resin content is too lower, the filling of the voids of glass fabrics will spare so that the consistency of the warp-wise and weft-wise of dielectric constant will not be achieved to affect the time delay of signal transmission.

According to the present invention, the pre-treated glass fabric has a resin content of from 25 wt.% to 50 wt.% when the pre-treated glass fabric has a mass per unit area of less than 30 g/m$^2$. The pre-treated glass fabric has a resin content of from 20 wt.% to 45 wt.% when the pre-treated glass fabric has a mass per unit area of from 30 g/m$^2$ to 100 g/m$^2$. The pre-treated glass fabric has a resin content of from 20 wt.% to 40 wt.% when the pre-treated glass fabric has a mass per unit area of from 100 g/m$^2$ to 175 g/m$^2$.

The resin content of the pre-treated glass fabric is chosen according to the mass per unit area of glass fabric. If the resin content is too higher, the pre-dipped varnish after main dipping will be mixed with the main-dipped varnish, so as to affect the gluing amount of the main-dipping glue. Meanwhile, since the Dk of general glass fabrics is far higher than the Dk of the main-dipping varnish, the Dk of the prepared board after main-dipping will be so higher that the dielectric performance of circuit substrate will become worse. If the resin content is too lower, the filling of the gaps of glass fabrics will spare so that the consistency of the warp-wise and weft-wise of dielectric constant will not be achieved, so as to affect the time delay of signal transmission.

According to the present invention, the resin composition comprises a resin and a hardener, wherein the resin is one or a mixture of at least two selected from the group consisting of epoxy resin, cyanate resin, polyphenyl ether resin, polybutadiene resin, copolymer resin of polybutadiene and styrene, polytetrafluoroethylene resin, polybenzoxazine resin, polyimide, silicon-containing resin, bismaleimide resin, liquid crystal polymer, bismaleimide triazine resin and thermoplastic resin.

The hardener is one or more selected from the group consisting of phenolic hardener, amine hardener, polymeric acid anhydride hardener, active ester and free radical initiator.

According to the present invention, the filler is one or more selected from the group consisting of silica (molten amorphous silica and crystalline silica), alumina, titanium dioxide (rutile-type titanium dioxide and anatase type titanium dioxide), barium titanate, strontium titanate, magnesium titanate, calcium titanate, barium strontium titanate, lead titanate and glass dust, wherein molten amorphous silica is preferred, and rutile-type titanium dioxide is preferred.

According to the present invention, to pre-treat glass fabric is to oven-dry organic solvent in the resin varnish. During the oven-drying process, the pre-treating varnish on glass fabric may be crosslinked or not.

According to the present invention, the method of pre-treating the E-type glass fabrics is characterized in,

Step 1: searching or testing the Dk (10 GHz) value of E-type glass fabrics according to the E-type glass fabrics chosen therein.

Step 2: preparing a pre-treating varnish according to the Dk (10 GHz) value of the chosen E-type glass fabrics, wherein the pre-treating varnish uses a resin composition having a Dk equivalent to Dk+ 10%, preferably Dk$\pm$5%, of E-type glass fabrics.

Step 3: adjusting the technological parameters, such as the gap of the clip axis of the gluing machine, gluing speed of the gluing machine and the like, according to the mass per unit area of the pre-treated glass fabrics in combination with the solid content of the pre-treated varnish. When the pre-treated glass fabrics have a mass per unit area of < 30g/m$^2$, the resin content can be controlled within the range of from 25 wt.% to 50 wt.%; when the pre-treated glass fabrics have a mass per unit area of from 30 g/m$^2$ to 100 g/m$^2$, the resin content can be controlled within the range of from 20 wt.% to 45 wt.%; when the pre-treated glass fabrics have a mass per unit area of from 100 g/m$^2$ to 175 g/m$^2$, the resin content can be controlled within the range of from 20 wt.% to 40 wt.%.

Step 4: oven-drying organic solvent in the pre-glue-dipped E-type glass fabrics to obtain specially pre-treated E-type glass fabrics.

According to the present invention, the process for pre-treating the NE-type glass fabrics is characterized in,

Step 1: searching or testing the Dk (10 GHz) value of NE-type glass fabrics according to the NE-type glass fabrics chosen therein.

Step 2: preparing a pre-treating varnish according to the Dk (10 GHz) value of the chosen NE-type glass fabrics, wherein the pre-treating varnish uses a resin composition having a Dk equivalent to Dk+ 10%, preferably Dk$\pm$5%, of NE-type glass fabrics.

Step 3: adjusting the technological parameters, such as the gap of the clip axis of the gluing machine, gluing speed of the gluing machine and the like, according to the mass per unit area of the pre-treated glass fabrics in combination with the solid content of the pre-treated varnish. When the pre-treated glass fabrics have a mass per unit area of < 30 g/m$^2$, the resin content can be controlled within the range of from 25 wt.% to 50 wt.%; when the pre-treated glass fabrics have a mass per unit area of from 30 g/m$^2$ to 100 g/m$^2$, the resin content can be controlled within the range of from 20 wt.% to 45 wt.%; when the pre-treated glass fabrics have a mass per unit area of from 100 g/m$^2$ to 175 g/m$^2$, the resin content can be controlled within the range of from 20 wt.% to 40 wt.%.

Step 4: oven-drying organic solvent in the pre-glue-dipped NE-type glass fabrics to obtain specially pre-treated NE-type glass fabrics.

The second aspect of the present invention lies in providing a bonding sheet, comprising the specially pre-treated glass fabrics above and the resin composition glue-dipped onto the specially pre-treated glass fabrics.

According to the present invention, the resin composition comprises resins and hardeners, wherein the resin is one or more selected from the group consisting of epoxy resin, cyanate resin, polyphenyl ether resin, polybutadiene resin, copolymer resin of polybutadiene and styrene, polytetrafluoroethylene resin, polybenzoxazine resin, polyimide, silicon-containing resin, bismaleimide resin, liquid crystal polymer and bismaleimide triazine resin.

According to the present invention, the resin composition may also include fillers, thermoplastic resins, different flame-retardant compounds or additives, which may be used separately or in combination.

The third aspect of the present invention provides a circuit substrate using the bonding sheet as described in the second aspect of the present invention.

As a typical, but not limitative example, the process for producing the circuit substrate may include the following steps.

Step 1: preparing a pre-treating varnish. According to the Dk of glass fabrics used therein, a pre-treating varnish is prepared. After the solvent is oven-dried from the pre-treating varnish, the dry glue has a same or close Dk to that of glass fabrics used therein.

Step 2: preparing a pre-treated glass fabric. Glass fabric is pre-glue-dipped with the aforesaid pre-treating varnish, and then the solvent is oven-dried to obtain the pre-treated glass fabric.

Step 3: preparing a bonding sheet. The aforesaid pre-treated glass fabric is main-glue-dipped, and then the solvent was oven-dried to obtain the bonding sheet.

Step 4: One or more bonding sheets were superimposed together, and one metal foil was laminated to each of both sides of the superimposed bonding sheets. The superimposed laminates were placed into a press for hot pressing to obtain said circuit substrate, wherein the curing temperature was from 100°C to 400°C; the curing time was from 1 h to 4 h; the curing pressure was from 10 Kgf/cm$^2$ to 65 Kgf/cm$^2$.

As compared with the prior art, the present invention has the following beneficial effects.

(1) As compared with general circuit substrate, the circuit substrate of the present invention is characterized in less warp-wise and weft-wise difference in dielectric constant, and can solve the problem of signal time delay when applied in high frequency field.

(2) As compared with glass-film pressing plate, the circuit substrate of the present invention uses a main-glue-dipped bonding sheet so that it will not be broken when pressed, and the interlaminar bonding force is greatly increased.

(3) As compared with glass-film pressing plate, the circuit substrate of the present invention uses a mainly-glue-dipped bonding sheet; the production process thereof is completely the same as that of conventional copper-clad plate, without any equipment upgrading and adjustment.

(4) As compared with the fiber-opened cloth, the circuit substrate of the present invention has the advantages of low cost and less warp-wise and weft-wise difference in dielectric constant, and can solve the problem of signal time delay when applied in high frequency field.

### Examples

In order to better illustrate the present invention so as to understand the technical solution of the present invention, the examples of the present invention are as follows.

As to the circuit substrate prepared above, the performances thereof, such as dielectric constant (Dk), dielectric loss (Df), signal time delay and the like, are measured, and further and detailedly stated and described in the following examples, wherein the mass part of organic resins are based on the mass part of organic solid substances.

### Example 1

E-type 1080 glass fabrics (having a mass per unit area of 46.8 g/m$^2$) were used as reinforcing material. Epoxy resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 40 parts by mass of epoxy resin composition, and a suitable amount of butanone solvent were added into a suitable container, stirred for a certain time. 52 parts by mass of rutile-type titanium dioxide filler and 8 parts by mass of amorphous silica filler were then added, sufficiently stirred, emulsified and dispersed to form the pre-treating varnish having a Dk of 6.6.

Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 45 wt.%.

Step 3: preparing a bonding sheet. A conventional epoxy resin system varnish having a varnish Dk of 3.8 was used to main-glue-dip the pre-treated E-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 190°C; the curing time was 2 h; the curing pressure was 35 Kgf/cm$^2$.

**Example 2**

E-type 1080 glass fabrics (having a mass per unit area of 46.8 g/m$^2$) were used as reinforcing material. Epoxy resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 42 parts by mass of epoxy resin composition, and a suitable amount of butanone solvent were added into a suitable container, stirred for a certain time. 50 parts by mass of rutile-type titanium dioxide filler and 8 parts by mass of amorphous silica filler were then added, sufficiently stirred, emulsified and dispersed to form the pre-treating varnish having a Dk of 6.5.
Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 45 wt.%.
Step 3: preparing a bonding sheet. A conventional polyphenyl ether resin system varnish having a varnish Dk of 2.6 was used to main-glue-dip the pre-treated E-type glass fabric, and then the solvent was oven-dried to obtain the bonding sheet.
Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Example 3**

E-type 1080 glass fabrics (having a mass per unit area of 46.8 g/m$^2$) were used as reinforcing material. Cyanate resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 40 parts by mass of cyanate resin composition, and a suitable amount of butanone solvent were added into a suitable container, stirred for a certain time. 54 parts by mass of rutile-type titanium dioxide filler and 6 parts by mass of amorphous silica filler were then added, sufficiently stirred, emulsified and dispersed to form the pre-treating varnish having a Dk of 6.5.
Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 45 wt.%.
Step 3: preparing a bonding sheet. A conventional polyphenyl ether resin system varnish having a varnish Dk of 2.6 was used to main-glue-dip the pre-treated E-type glass fabric, and then the solvent was oven-dried to obtain the bonding sheet.
Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Example 4**

E-type 1080 glass fabrics (having a mass per unit area of 46.8 g/m$^2$) were used as reinforcing material. Polyphenyl ether resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 38 parts by mass of polyphenyl ether resin composition, and a suitable amount of xylene solvent were added into a suitable container, stirred for a certain time. 54 parts by mass of rutile-type titanium dioxide filler and 8 parts by mass of amorphous silica filler were then added, sufficiently stirred, emulsified and dispersed to form the pre-treating varnish having a Dk of 6.4.
Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 30 wt.%.

Step 3: preparing a bonding sheet. A conventional cyanate resin system varnish having a varnish Dk of 3.2 was used to main-glue-dip the pre-treated E-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Example 5**

E-type 1080 glass fabrics (having a mass per unit area of 46.8 g/m$^2$) were used as reinforcing material. Polybutadiene resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 34 parts by mass of polybutadiene resin composition, and a suitable amount of xylene solvent were added into a suitable container, stirred for a certain time. 56 parts by mass of rutile-type titanium dioxide filler and 10 parts by mass of amorphous silica filler were then added, sufficiently stirred, emulsified and dispersed to form the pre-treating varnish having a Dk of 6.2.

Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 20 wt.%.

Step 3: preparing a bonding sheet. A conventional polyphenyl ether resin composition varnish having a varnish Dk of 2.6 was used to main-glue-dip the pre-treated E-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 240°C; the curing time was 3 h; the curing pressure was 55 Kgf/cm$^2$.

**Example 6**

E-type 1500 glass fabrics (having a mass per unit area of 164.1 g/m$^2$) were used as reinforcing material. The pre-treated glass fabric had a resin content of 25 wt.%. The rest is the same as that in Example 5.

**Example 7**

NE-type 3313 glass fabrics (having a mass per unit area of 81.4 g/m$^2$) were used as reinforcing material. Epoxy resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 50 parts by mass of epoxy resin composition, and a suitable amount of butanone solvent were added into a suitable container, stirred for a certain time. 42 parts by mass of rutile-type titanium dioxide filler and 8 parts by mass of amorphous silica filler were then added, sufficiently stirred, emulsified and dispersed to form the pre-treating varnish having a Dk of 4.6.

Step 2: preparing a pre-treated NE-type glass fabric. NE-type glass fabric was pre-glue-dipped with the aforesaid pre-treating varnish, and then the solvent was oven-dried to obtain the pre-treated glass fabric having a resin content of 20 wt.%.

Step 3: preparing a bonding sheet. A conventional cyanate resin composition varnish having a varnish Dk of 3.2 was used to main-glue-dip the pre-treated NE-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Example 8**

NE-type 2116 glass fabrics (having a mass per unit area of 103.8 g/m$^2$) were used as reinforcing material. Cyanate resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 50 parts by mass of cyanate resin composition, and a suitable amount of butanone solvent were added into a suitable container, stirred for a certain time. 44 parts by mass of rutile-type titanium dioxide filler and 6 parts by mass of amorphous silica filler were then added, sufficiently stirred, emulsified and dispersed to form the pre-treating varnish having a Dk of 4.4.

Step 2: preparing a pre-treated NE-type glass fabric. NE-type glass fabric was pre-glue-dipped with the aforesaid pre-treating varnish, and then the solvent was oven-dried to obtain the pre-treated glass fabric having a resin content of 30 wt.%.

Step 3: preparing a bonding sheet. A conventional cyanate resin composition varnish having a varnish Dk of 3.2 was used to main-glue-dip the pre-treated NE-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Example 9**

NE-type 1078 glass fabrics (having a mass per unit area of 47.8 g/m$^2$) were used as reinforcing material. Polyphenyl ether resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 48 parts by mass of polyphenyl ether resin composition, and a suitable amount of xylene solvent were added into a suitable container, stirred for a certain time. 44 parts by mass of rutile-type titanium dioxide filler and 8 parts by mass of amorphous silica filler were then added, sufficiently stirred, emulsified and dispersed to form the pre-treating varnish having a Dk of 4.5.

Step 2: preparing a pre-treated NE-type glass fabric. NE-type glass fabric was pre-glue-dipped with the aforesaid pre-treating varnish, and then the solvent was oven-dried to obtain the pre-treated glass fabric having a resin content of 45 wt.%.

Step 3: preparing a bonding sheet. A conventional polyphenyl ether resin composition varnish having a varnish Dk of 2.6 was used to main-glue-dip the pre-treated NE-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Example 10**

NE-type 106 glass fabrics (having a mass per unit area of 24.4 g/m$^2$) were used as reinforcing material. Polybutadiene resin composition was dissolved in solvent, and fillers were added as pre-treating varnish. The composition and formula of the varnish and the physical property data of circuit substrate are shown in Table 1. The circuit substrate was prepared by the following steps.

Step 1: preparing a pre-treating varnish. 44 parts by mass of polybutadiene resin composition, and a suitable amount of xylene solvent were added into a suitable container, stirred for a certain time. 46 parts by mass of rutile-type titanium dioxide filler and 10 parts by mass of amorphous silica filler were then added, sufficiently stirred, emulsified and dispersed to form the pre-treating varnish having a Dk of 4.5.

Step 2: preparing a pre-treated NE-type glass fabric. NE-type glass fabric was pre-glue-dipped with the aforesaid pre-treating varnish, and then the solvent was oven-dried to obtain the pre-treated glass fabric having a resin content of 50 wt.%.

Step 3: preparing a bonding sheet. A conventional polyphenyl ether resin composition varnish having a varnish Dk of 2.6 was used to main-glue-dip the pre-treated NE-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 240°C; the curing time was 3 h; the curing pressure was 55 Kgf/cm$^2$.

Table 1 Formula composition and physical property data of each example

| Examples | 1 | 2 | 3 | 4 | 5 | 6 | 7 | 8 | 9 | 10 |
|---|---|---|---|---|---|---|---|---|---|---|
| Types of glass fabrics | E-type | E-type | E-type | E-type | E-type | E-type | NE-type | NE-type | NE-type | NE-type |
| Models of glass fabrics | 1080 | 1080 | 1080 | 1080 | 1080 | 1500 | 3313 | 2116 | 1078 | 106 |
| Pre-treating varnish resin system | epoxy | epoxy | cyanate | Polyphenyl ether | Polybutadiene | Polybutadiene | epoxy | cyanate | Poly-phenyl ether | Polybutadiene |
| Dk of Pre-treating varnish | 6.6 | 6.5 | 6.5 | 6.4 | 6.2 | 6.2 | 4.6 | 4.4 | 4.5 | 4.5 |
| Resin content of pre-treated glass fabrics | 45wt% | 45wt% | 45wt% | 30wt% | 20wt% | 25wt% | 20wt% | 30wt% | 45wt% | 50wt% |
| Main-dipping glue resin system | epoxy | Polyphenyl ether | Polyphenyl ether | cyanate | Polyphenyl ether | Polyphenyl ether | cyanate | cyanate | Polyphenyl ether | Polyphenyl ether |
| Dk of Main-dipping glue varnish | 3.8 | 2.6 | 2.6 | 3.2 | 2.6 | 2.6 | 3.2 | 3.2 | 2.6 | 2.6 |
| Dk of Circuit substrate | 4.6 | 4.2 | 4.2 | 4.0 | 3.3 | 3.5 | 3.5 | 3.6 | 3.5 | 3.6 |
| Df of circuit substrate | 0.015 | 0.007 | 0.007 | 0.008 | 0.006 | 0.006 | 0.009 | 0.006 | 0.005 | 0.004 |
| Warp-wise signal time delay/ps | 3 | 5 | 5 | 7 | 9 | 8 | 7 | 6 | 4 | 3 |
| Weft-wise signal time delay/ps | 1 | 2 | 2 | 2 | 3 | 3 | 2 | 2 | 1 | 1 |

**Example 11**

E-type 2116 glass fabrics (having a mass per unit area of 103.8 g/m$^2$) were used as reinforcing material. Cyanate resin composition was dissolved in solvent, and fillers were added as pre-treating varnish. The composition and formula of the varnish and the physical property data of circuit substrate are shown in Table 2. The circuit substrate was prepared by the following steps.

Step 1: preparing a pre-treating varnish. 40 parts by mass of cyanate resin composition, and a suitable amount of butanone solvent were added into a suitable container, stirred for a certain time. 54 parts by mass of rutile-type titanium dioxide filler and 6 parts by mass of amorphous silica filler were then added, sufficiently stirred, emulsified and dispersed to form the pre-treating varnish having a Dk of 6.5.
Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 35 wt.%.
Step 3: preparing a bonding sheet. A conventional cyanate resin composition varnish having a varnish Dk of 3.2 was used to main-glue-dip the pre-treated E-type glass fabric, and then the solvent was oven-dried to obtain the bonding sheet.
Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Comparison Example 1**

E-type 1080 glass fabrics (having a mass per unit area of 46.8 g/m$^2$) were used as reinforcing material. The pre-treated glass fabrics had a resin content of 10 wt.%. The rest is the same as that in Example 1.

**Comparison Example 2**

E-type 1080 glass fabrics (having a mass per unit area of 46.8 g/m$^2$) were used as reinforcing material. Cyanate resin composition was dissolved in solvent, and fillers were added as pre-treating varnish. The composition and formula of the varnish and the physical property data of circuit substrate are shown in Table 2. The circuit substrate was prepared by the following steps.

Step 1: preparing a pre-treating varnish. 70 parts by mass of cyanate resin composition, and a suitable amount of butanone solvent were added into a suitable container, stirred for a certain time. 24 parts by mass of rutile-type titanium dioxide filler and 6 parts by mass of amorphous silica filler were then added, sufficiently stirred, emulsified and dispersed to form the pre-treating varnish having a Dk of 5.2.
Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 45 wt.%.
Step 3: preparing a bonding sheet. A conventional polyphenyl ether resin composition varnish having a varnish Dk of 2.6 was used to main-glue-dip the pre-treated E-type glass fabric, and then the solvent was oven-dried to obtain the bonding sheet.
Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Comparison Example 3**

E-type 1080 glass fabrics (having a mass per unit area of 46.8 g/m$^2$) were used as reinforcing material. Polyphenyl ether resin composition was dissolved in solvent, and fillers were added as pre-treating varnish. The composition and formula of the varnish and the physical property data of circuit substrate are shown in Table 2. The circuit substrate was prepared by the following steps.

Step 1: preparing a pre-treating varnish. 22 parts by mass of polyphenyl ether resin composition, and a suitable amount of xylene solvent were added into a suitable container, stirred for a certain time. 70 parts by mass of rutile-type titanium dioxide filler and 8 parts by mass of amorphous silica filler were then added, sufficiently stirred, emulsified and dispersed to form the pre-treating varnish having a Dk of 7.8.

Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 30 wt.%.

Step 3: preparing a bonding sheet. A conventional cyanate resin composition varnish having a varnish Dk of 3.2 was used to main-glue-dip the pre-treated E-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Comparison Example 4**

E-type 1080 glass fabrics (having a mass per unit area of 46.8 g/m$^2$) were used as reinforcing material. The pre-treated glass fabrics had a resin content of 60 wt.%. The rest is the same as that in Example 5.

**Comparison Example 5**

NE-type 3313 glass fabrics (having a mass per unit area of 81.4 g/m$^2$) were used as reinforcing material. The pre-treated glass fabrics had a resin content of 15 wt.%. The rest is the same as that in Example 7.

**Comparison Example 6**

NE-type 106 glass fabrics (having a mass per unit area of 24.4 g/m$^2$) were used as reinforcing material. The pre-treated glass fabrics had a resin content of 62 wt.%. The rest is the same as that in Example 10.

**Comparison Example 7**

E-type 2116 glass fabrics (having a mass per unit area of 103.8 g/m$^2$) were used as reinforcing material. Cyanate resin composition was dissolved in solvent, and fillers were added as pre-treating varnish. The composition and formula of the varnish and the physical property data of circuit substrate are shown in Table 2. The circuit substrate was prepared by the following steps.

Step 1: preparing a conventional resin composition varnish. 90 parts by mass of cyanate resin composition, and a suitable amount of butanone solvent were added into a suitable container, stirred for a certain time. 10 parts by mass of amorphous silica filler were then added, sufficiently stirred to obtain the conventional cyanate resin composition varnish having a Dk of 3.2.

Step 2: preparing a pre-treated E-type glass fabric. E-type glass fabric was pre-glue-dipped with the aforesaid pre-treating varnish, and then the solvent was oven-dried to obtain the pre-treated glass fabric having a resin content of 35 wt.%.

Step 3: preparing a bonding sheet. A conventional cyanate resin composition varnish having a varnish Dk of 3.2 was used to main-glue-dip the pre-treated E-type glass fabric, and then the solvent was oven-dried to obtain the bonding sheet.

Step 4: One or more bonding sheets were superimposed together, and one copper foil was laminated to each of both sides of the superimposed bonding sheets. The superimposed laminates were placed into a press for hot pressing to obtain said circuit substrate, wherein the curing temperature was 200°C; the curing time was 2 h; the curing pressure was 35 Kgf/cm$^2$.

**Comparison Example 8**

E-type 1080 glass fabrics (having a mass per unit area of 46.8 g/m$^2$) were used as reinforcing material. Epoxy resin composition was dissolved in solvent, and fillers were added as pre-treating varnish. The composition and formula of the varnish and the physical property data of circuit substrate are shown in Table 2. The circuit substrate was prepared by the following steps.

Step 1: preparing a varnish. 85 parts by mass of epoxy resin composition, and a suitable amount of butanone solvent were added into a suitable container, stirred for a certain time. 15 parts by mass of amorphous silica filler were then added, sufficiently stirred to obtain the epoxy resin composition varnish having a Dk of 3.8.

Step 2: preparing a bonding sheet. E-type glass fabric was glue-dipped with the aforesaid resin composition varnish having a Dk of 3.8, and then the solvent was oven-dried to obtain the bonding sheet.

Step 3: One or more bonding sheets were superimposed together, and one copper foil was laminated to each of both sides of the superimposed bonding sheets. The superimposed laminates were placed into a press for hot pressing to obtain said circuit substrate, wherein the curing temperature was 190°C; the curing time was 2 h; the curing pressure was 35 Kgf/cm$^2$.

## Comparison Example 9

E-type 1080 glass fabrics (having a mass per unit area of 46.8 g/m$^2$) were used as reinforcing material. A conventional epoxy resin composition varnish having a Dk of 3.8 was used as varnish for glue-dipping fiber-opening glass fabrics. The composition and formula of the varnish and the physical property data of circuit substrate are shown in Table 2. The circuit substrate was prepared by the following steps.

Step 1: preparing a varnish. 85 parts by mass of epoxy resin composition, and a suitable amount of butanone solvent were added into a suitable container, stirred for a certain time. 15 parts by mass of amorphous silica filler were then added, sufficiently stirred to obtain the epoxy resin composition varnish having a Dk of 3.8.

Step 2: preparing a bonding sheet. Fiber-open glass fabric was glue-dipped with the aforesaid epoxy resin composition varnish having a Dk of 3.8, and then the solvent was oven-dried to obtain the bonding sheet.

Step 3: One or more bonding sheets were superimposed together, and one copper foil was laminated to each of both sides of the superimposed bonding sheets. The superimposed laminates were placed into a press for hot pressing to obtain said circuit substrate, wherein the curing temperature was 190°C; the curing time was 2 h; the curing pressure was 35 Kgf/cm$^2$.

Table 2 Formula composition and physical property data of Example 11 and Comparison Examples 1-9

| Examples | Example. 11 | Com. Example. 1 | Com. Example. 2 | Com. Example.3 | Com. Example.4 | Com. Example. 5 | Com. Example.6 | Com. Example. 7 | Com. Example. 8 | Com. Example. 9 |
|---|---|---|---|---|---|---|---|---|---|---|
| Types of glass fabrics | E-Type | E-Type | E-Type | E-Type | E-Type | NE- Type | NE- Type | E-Type | E-Type | E-type fiber-opened |
| Models of glass fabrics | 2116 | 1080 | 1080 | 1080 | 1080 | 3313 | 106 | 2116 | 1080 | 1080 |
| Pre-treating varnish resin system | Cyanate | Epoxy | Cyanate | Polyphenyl ether | Polybutadiene | Epoxy | Polybutadiene | Cyanate | - | - |
| Dk of Pre-treating varnish | 6.5 | 6.6 | 5.2 | 7.8 | 6.2 | 4.6 | 4.5 | 3.2 | - | - |
| Resin content of pre-treated glass fabrics | 35wt% | 10wt% | 45wt% | 30wt% | 60wt% | 15wt% | 62wt% | 35wt% | - | - |
| Main-dipping glue resin system | Cyanate | Epoxy | Polyphenyl ether | Cyanate | Poly- phenyl ether | Cyanate | Poly- phenyl ether | Cyanate | Epoxy | Epoxy |
| Dk of Main-dipping glue varnish | 3.2 | 3.8 | 2.6 | 3.2 | 2.6 | 3.2 | 2.6 | 3.2 | 3.8 | 3.8 |
| Dk of Circuit substrate | 4.4 | 4.1 | 3.8 | 4.6 | 4.8 | 3.4 | 4.1 | 3.9 | 4.3 | 4.1 |
| Df of circuit substrate | 0.008 | 0.012 | 0.006 | 0.007 | 0.006 | 0.008 | 0.004 | 0.009 | 0.016 | 0.012 |
| Warp-wise signal time delay/ps | 9 | 35 | 41 | 48 | 4 | 32 | 3 | 45 | 40 | 28 |
| Weft-wise signal time delay/ps | 8 | 13 | 25 | 30 | 7 | 15 | 6 | 15 | 13 | 11 |

The performances above are measured by the following methods:

(1) Dielectric performance Dk/Df: measuring the dielectric constant Dk and dielectric loss Df of the plate under 10 GHz by the SPDR method.
(2) Signal time delay: measured according to the method stipulated under IPC TM-650 2.5.5.11, wherein the test frequency was 12.5 GHz, and the test wire length was 40 inch. Based on different directions of transmission line on the circuit substrate, the signal time delay during the test was divided into warp-wise signal time delay and weft-wise signal time delay. Warp-wise signal time delay refers to the signal time delay measured when the transmission line is warp-wisely arranged on the circuit substrate; weft-wise signal time delay refers to the signal time delay measured when the transmission line is weft-wisely arranged on the circuit substrate.
(3) Resin content: measured according to the method stipulated under IPC TM-650 2.3.16.1.

Analyses of physical property results:

According to Tables 1 and 2, it can be seen that, in Comparison Examples 1 and 5 as compared with Examples 1 and 7 respectively, the resin content of the pre-treated glass fabric was too low, so that the gaps of glass fabrics were not fully filled, and the circuit substrate had the problem of signal time delay. In Comparison Example 2 as compared with Example 3, the Dk of the pre-treating varnish was very lower than that of glass fabric, and the circuit substrate had the problem of signal time delay. In Comparison Example 3 as compared with Example 4, the Dk of the pre-treating varnish was very higher than that of glass fabric, and the circuit substrate had the problem of signal time delay. In Comparison Examples 4 and 6 as compared with Examples 5 and 6 respectively, although the circuit substrate had no signal time delay, the resin content of the pre-treated glass fabrics was too higher so as to reduce the gluing amount of the main-glue-dipping glue and result in a higher Dk of the circuit substrate. In Comparison Example 7 as compared with Example 11, although glass fabric was pre-treated and main-glue-dipped, the same varnish was used in the pre-treatment and main- glue-dipping. Moreover, the Dk of the pre-treating varnish was greatly different from that of glass fabric, and the circuit substrate had the problem of signal time delay. Comparison Example 8 relates to a common production mode of circuit substrate, wherein one-time glue-dipping was used; the Dk of the varnish was greatly different from that of glass fabric. As compared with Example 1, the circuit substrate had the problem of signal time delay. In Comparison Example 9, fiber-opened glass fabric was used for one-time glue-dipping, wherein the Dk of the varnish was greatly different from that of glass fabric. As compared with Example 1, the circuit substrate still had the problem of signal time delay, especially in warp-wise direction.

**Claims**

1. A process for preparing a bonding sheet for composing circuit substrate, comprising the steps of

(1) preparing a pre-treating varnish having a dielectric constant (DK) equal to DK $\pm$ 5% of glass fabric being used, the dielectric constant is measured by SPDR method under a frequency of 10 GHz;
(2) pre-glue-dipping the glass fabric in the pre-treating varnish, and oven-drying solvent to obtain a pre-treated glass fabric; and
(3) main-glue-dipping the pre-treated glass fabric, and oven-drying solvent to obtain a bonding sheet;

wherein the pre-treated glass fabric has a resin content of from 25 wt.% to 50 wt.% and has a mass per unit area of less than 30 $g/m^2$; or alternatively, the pre-treated glass fabric has a resin content of from 20 wt.% to 45 wt.% and has a mass per unit area of from 30 $g/m^2$ to 100 $g/m^2$; or alternatively, the pre-treated glass fabric has a resin content of from 20 wt.% to 40 wt.% and has a mass per unit area of from 100 $g/m^2$ to 175 $g/m^2$.

2. The process according to claim 1, **characterized in that** the pre-treating varnish is obtained by dissolving a resin composition in an organic solvent.

3. The process according to claim 2, **characterized in that** the resin composition comprises a resin and a hardener, wherein the resin is one or a mixture of at least two selected from the group consisting of epoxy resin, cyanate resin, polyphenyl ether resin, polybutadiene resin, copolymer resin of polybutadiene and styrene, polytetrafluoroethylene resin, polybenzoxazine resin, polyimide, silicon-containing resin, bismaleimide resin, liquid crystal polymer, bismaleimide triazine resin and thermoplastic resin.

4. The process according to claim 3, **characterized in that** the hardener is one or more selected from the group consisting of phenolic hardener, amine hardener, polymeric acid anhydride hardener, active ester and free radical initiator.

5. The process according to claim 2, **characterized in that** the organic solvent is one or a mixture of at least two selected from the group consisting of alcohol such as methanol, ethanol, butanol and the like, ether such as ethyl cellosolve, butyl cellosolve, ethylene glycol monomethyl ether, diethylene glycol ether, diethylene glycol butyl ether and the like, ketone such as acetone, butanone, methyl ethyl ketone, methyl isobutyl ketone, cyclohexanone and the like, aromatic hydrocarbon such as toluene, xylene, sym-trimethylbenzene and the like, ester such as ethoxyethyl acetate, ethyl acetate and the like, and nitrogen-containing solvent such as N,N-dimethylformamide, N,N-dimethylacetamide, N-methyl-2-pyrrolidone and the like.

6. The process according to claim 3, **characterized in that** the pre-treating varnish further comprises a filler selected from the group consisting of silica, alumina, titanium dioxide, barium titanate, strontium titanate, magnesium titanate, calcium titanate, barium strontium titanate, lead titanate and glass dust, wherein said silica comprises molten amorphous silica and crystalline silica, preferably molten amorphous silica; said titanium dioxide comprises rutile-type titanium dioxide and anatase type titanium dioxide, preferably rutile-type titanium dioxide.

7. The process according to claim 1, **characterized in that** the glass fabric is an E-type one, and the corresponding treating varnish has a DK of from 6.2 to 6.6, or the glass fabric is an NE-type one, and the corresponding treating varnish has a DK of from 4.4 to 4.6.

8. The process according to claim 1, **characterized in that** the pre-treating varnish has a DK within the range of DK±5% of glass fabric.

9. A bonding sheet prepared according to the process of one of claims 1-8.

10. A circuit substrate prepared from the bonding sheet according to claim 9.

11. A printed-circuit substrate prepared from the circuit substrate according to claim 10.

**Patentansprüche**

1. Verfahren zur Herstellung einer Bindungsfolie zum Zusammensetzen eines Schaltungssubstrats, umfassend die folgenden Schritte:

   (1) Herstellen eines Vorbehandlungslacks mit einer Dielektrizitätskonstante (DK) von DK ± 5% eines verwendeten Glasgewebes, wobei die Dielektrizitätskonstante durch das SPDR-Verfahren bei einer Frequenz von 10 GHz bestimmt wird;
   (2) Vorkleben mittels Eintauchen des Glasgewebes in den Vorbehandlungslack und Ofentrocknen von Lösungsmittel, um ein vorbehandeltes Glasgewebe zu erhalten; und
   (3) Hauptkleben des vorbehandelten Glasgewebes und Ofentrocknen von Lösungsmittel, um eine Bindungsfolie zu erhalten;

   wobei das vorbehandelte Glasgewebe einen Harzgehalt von 25 Gew.-% bis 50 Gew.-% und eine Masse pro Flächeneinheit von weniger als 30 g/m$^2$ aufweist; oder
   wobei das vorbehandelte Glasgewebe alternativ einen Harzgehalt von 20 Gew.-% bis 45 Gew.-% und eine Masse pro Flächeneinheit von 30 g/m$^2$ bis 100 g/m$^2$ aufweist; oder
   wobei das vorbehandelte Glasgewebe alternativ einen Harzgehalt von 20 Gew.-% bis 40 Gew.-% und eine Masse pro Flächeneinheit von 100 g/m$^2$ bis 175 g/m$^2$ aufweist.

2. Verfahren nach Anspruch 1, **dadurch gekennzeichnet, dass** der Vorbehandlungslack durch Auflösen einer Harzzusammensetzung in einem organischen Lösungsmittel erhalten wurde.

3. Verfahren nach Anspruch 2, **dadurch gekennzeichnet, dass** die Harzzusammensetzung ein Harz und ein Härtungsmittel umfasst, wobei das Harz eines oder eine Mischung von mindestens zweien ausgewählt aus der Gruppe bestehend aus Epoxidharz, Cyanatharz, Polyphenyletherharz, Polybutadienharz, Copolymerharz aus Polybutadien und Styrol, Polytetrafluorethylenharz, Polybenzoxazinharz, Polyimid, siliciumhaltiges Harz, Bismaleimidharz, Flüssigkristallpolymer, Bismaleimidtriazinharz und thermoplastischem Harz ist.

4. Verfahren nach Anspruch 3, **dadurch gekennzeichnet, dass** das Härtungsmittel eines oder mehrere ausgewählt aus der Gruppe bestehend aus phenolischem Härtungsmittel, Amin-Härtungsmittel, polymerem Säureanhydrid-Härtungsmittel, Aktivester und Radikalstarter ist.

5. Verfahren nach Anspruch 2, **dadurch gekennzeichnet, dass** das organische Lösungsmittel eines oder eine Mischung von mindestens zweien ausgewählt aus der Gruppe bestehend aus Alkohol wie zum Beispiel Methanol, Ethanol, Butanol und dergleichen, Ether wie zum Beispiel Ethylcellosolve, Butylcellosolve Ethylenglykolmonomethylether, Diethylenglykolether, Diethylenglykolbutylether und dergleichen, Keton wie zum Beispiel Aceton, Butanon, Methylethylketon, Methylisobutylketon, Cyclohexanon und dergleichen, aromatischem Kohlenwasserstoff wie zum Beispiel Toluol, Xylol, Sym-Trimethylbenzol und dergleichen, Ester wie zum Beispiel Ethoxyethylacetat, Ethylacetat und dergleichen und stickstoffhaltigem Lösungsmittel wie zum Beispiel N,N-Dimethylformamid, N,N-Dimethylacetamid, N-Methyl-2-pyrrolidon und dergleichen ist.

6. Verfahren nach Anspruch 3, **dadurch gekennzeichnet, dass** der Vorbehandlungslack ferner einen Füllstoff umfasst, der ausgewählt ist aus der Gruppe bestehend aus Siliciumdioxid, Aluminiumoxid, Titandioxid, Bariumtitanat, Strontiumtitanat, Magnesiumtitanat, Calciumtitanat, Bariumstrontiumtitanat, Bleititanat und Glasstaub, wobei das Siliciumdioxid geschmolzenes amorphes Siliciumdioxid und kristallines Siliciumdioxid umfasst, vorzugsweise geschmolzenes amorphes Siliciumdioxid; wobei das Titandioxid Titandioxid vom Rutiltyp und Titandioxid vom Anatas-Typ umfasst, vorzugsweise Titandioxid vom Rutiltyp.

7. Verfahren nach Anspruch 1, **dadurch gekennzeichnet, dass** das Glasgewebe eines vom E-Typ ist und der entsprechende Behandlungslack eine DK von 6,2 bis 6,6 aufweist oder das Glasgewebe eines vom NE-Typ ist und der entsprechende Behandlungslack eine DK von 4,4 bis 4,6 aufweist.

8. Verfahren nach Anspruch 1, **dadurch gekennzeichnet, dass** der Vorbehandlungslack eine DK im Bereich von DK $\pm$ 5% des Glasgewebes aufweist.

9. Bindungsfolie, hergestellt nach dem Verfahren eines der Ansprüche 1 bis 8.

10. Schaltungssubstrat, hergestellt aus der Bindungsfolie nach Anspruch 9.

11. Leiterplattensubstrat, hergestellt aus dem Schaltungssubstrat nach Anspruch 10.


**Revendications**

1. Procédé de préparation d'une feuille de collage pour composer un substrat de circuit, comprenant les étapes de

(1) préparation d'un vernis de pré-traitement ayant une constante diélectrique (DK) égale à DK $\pm$ 5 % de la toile de verre utilisée, la constante diélectrique est mesurée par la méthode SPDR (« Split Post Dielectric Resonators ») sous une fréquence de 10 GHz ;
(2) pré-immersion dans la colle de la toile de verre dans le vernis de pré-traitement, et séchage au four du solvant pour obtenir une toile de verre pré-traitée ; et
(3) immersion dans la colle principale de la toile de verre pré-traitée, et séchage au four du solvant pour obtenir une feuille de collage ;

dans lequel la toile de verre pré-traitée a une teneur en résine de 25 % en poids à 50 % en poids et a une masse par unité d'aire de moins de 30 g/m$^2$ ; ou en variante, la toile de verre pré-traitée a une teneur en résine de 20 % en poids à 45 % en poids et a une masse par unité d'aire de 30 g/m$^2$ à 100 g/m$^2$ ; ou en variante, la toile de verre pré-traitée a une teneur en résine de 20 % en poids à 40 % en poids et a une masse par unité d'aire de 100 g/m$^2$ à 175 g/m$^2$.

2. Procédé selon la revendication 1, **caractérisé en ce que** le vernis de pré-traitement est obtenu par dissolution d'une composition de résine dans un solvant organique.

3. Procédé selon la revendication 2, **caractérisé en ce que** la composition de résine comprend une résine et un durcisseur, dans lequel la résine est l'un ou un mélange d'au moins deux éléments choisis dans le groupe consistant en une résine époxy, une résine de cyanate, une résine de polyphényl éther, une résine de polybutadiène, une résine de copolymère de polybutadiène et de styrène, une résine de polytétrafluoroéthylène, une résine de polybenzoxazine, le polyimide, une résine contenant du silicium, une résine de bismaléimide, un polymère à cristaux liquides, une résine de bismaléimide triazine et une résine thermoplastique.

4. Procédé selon la revendication 3, **caractérisé en ce que** le durcisseur est un ou plusieurs éléments choisis dans le groupe consistant en un durcisseur phénolique, un durcisseur amine, un durcisseur anhydride d'acide polymérique, un ester actif et un initiateur de radicaux libres.

5. Procédé selon la revendication 2, **caractérisé en ce que** le solvant organique est l'un ou un mélange d'au moins deux éléments choisis dans le groupe consistant en un alcool tel que le méthanol, l'éthanol, le butanol et similaire, un éther tel que l'éthyl cellosolve, le butyl cellosolve, l'éthylène glycol monométhyl éther, le diéthylène glycol éther, le diéthylène glycol butyl éther et similaire, une cétone telle que l'acétone, la butanone, la méthyl éthyl cétone, la méthyl isobutyl cétone, la cyclohexanone et similaire, un hydrocarbure aromatique tel que le toluène, le xylène, le symtriméthylbenzène et similaire, un ester tel que l'acétate d'éthoxyéthyle, l'acétate d'éthyle et similaire, et un solvant contenant de l'azote tel que le N,N-diméthylformamide, le N,N-diméthylacétamide, la N-méthyl-2-pyrrolidone et similaire.

6. Procédé selon la revendication 3, **caractérisé en ce que** le vernis de pré-traitement comprend en outre une charge choisie dans le groupe consistant en la silice, l'alumine, le dioxyde de titane, le titanate de baryum, le titanate de strontium, le titanate de magnésium, le titanate de calcium, le titanate de baryum strontium, le titanate de plomb et la poudre de verre, dans lequel ladite silice comprend de la silice amorphe fondue et de la silice cristalline, de préférence de la silice amorphe fondue ; ledit dioxyde de titane comprend du dioxyde de titane de type rutile et du dioxyde de titane de type anatase, de préférence du dioxyde de titane de type rutile.

7. Procédé selon la revendication 1, **caractérisé en ce que** la toile de verre est de type E, et le vernis de traitement correspondant a une DK de 6,2 à 6,6, ou la toile de verre est de type NE, et le vernis de traitement correspondant a une DK de 4,4 à 4,6.

8. Procédé selon la revendication 1, **caractérisé en ce que** le vernis de pré-traitement a une DK dans la plage de DK ± 5 % de la toile de verre.

9. Feuille de collage préparée selon le procédé de l'une quelconque des revendications 1 à 8.

10. Substrat de circuit préparé à partir de la feuille de collage selon la revendication 9.

11. Substrat de circuit imprimé préparé à partir du substrat de circuit selon la revendication 10.

weft yarn

warp yarn

Fig. 1

weft yarn

warp yarn

Fig. 2

gaps

weft yarn

weft yarn

weft yarn

warp yarn

resin matrix

single yarn    weaving point

Fig. 3

Dk

warp-wise or weft-wise of glass fabrics

Fig. 4

Dk

warp-wise or weft-wise of glass fabrics

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 102548200 A
- EP 1140373 A
- CN 101494949 A
- CN 101570640 B